# EUROPÄISCHE PATENTSCHRIFT

(11) **EP 1 820 206 B1**
(45) Veröffentlichungstag und Bekanntmachung des Hinweises auf die Patenterteilung: **26.01.2011**
(21) Anmeldenummer: 05817513.4
(22) Anmeldetag: 02.12.2005
(51) Int. Cl.: H01L 21/00

(54) **THERMODENEINHEIT FÜR HALBLEITERBAUELEMENTE**
THERMODE UNIT FOR SEMICONDUCTOR COMPONENTS
UNITE THERMODENE POUR DES ELEMENTS A SEMI-CONDUCTEURS

(30) Priorität: 09.12.2004 DE 102004059281
(43) Veröffentlichungstag der Anmeldung: 22.08.2007
(73) Patentinhaber: Mühlbauer AG, 93426 Roding (DE)
(72) Erfinder: KLOOSS, Matthias, 01127 Dresden (DE)
(74) Vertreter: Schmidt, Steffen
(86) Internationale Anmeldenummer: PCT/EP2005/056403
(87) Internationale Veröffentlichungsnummer: WO 2006/061350

(56) Entgegenhaltungen:
- EP-A- 1 204 137
- US-A- 4 605 833
- US-A- 4 736 882

## Beschreibung

Die Erfindung betrifft eine Thermodeneinheit zum Verbinden und/oder elektrischen Kontaktieren eines ersten Halbleiterbauelementes mit einem Trägerelement und/oder einem zweiten Halbleiterbauelement mittels Erwärmung eines Klebstoffes unter Druckbeaufschlagung, wobei die Thermodeneinheit einen Grundkörper und eine entlang seiner Längsachse verschiebbare Heizkopfeinheit zum Anpressen des ersten Halbleiterbauelementes auf dem Trägerelement und/oder dem zweiten Halbleiterbauelement während einer Wärmeübertragung auf das erste Halbleiterbauelement umfasst, gemäß dem Oberbegriff des Patentanspruches 1.

Für die Herstellung von mikroelektronischen Baugruppen werden Halbleiterbauelemente, wie beispielsweise Silizium-Chips, auf Trägersubstrate, die eine Antenne aufweisen können, oder auf weitere Halbleiterbauelemente, die wiederum Silizium-Chips sein können, montiert. Für eine derartige Montage der Halbleiterbauelemente werden häufig Kontaktklebstoffe verwendet, um neben der Fixierung des Halbleiterbauelementes zugleich einen elektrischen Kontakt zwischen Anschlussstellen des Chips und des Trägersubstrates bzw. eines weiteren Chips herzustellen. Die hierfür verwendeten Kontaktklebstoffe oder auch Lote werden in der Regel mittels Thermodeneinheiten bei erhöhter Temperatur unter Druckbeaufschlagung aushärten gelassen.

Herkömmlicherweise weisen hierfür verwendete Thermodenelemente, wie es beispielsweise in US 4,736,882 gezeigt wird, einen unterseitigen Heizkörper auf, der entlang der Vertikalen nach unten und nach oben verschoben werden kann, um die zu verbindenden Bauteile und die dazwischen angeordneten Klebstoffe während eines Wärmeübertragungsvorganges mit Druck zu beaufschlagen oder freizugeben. Derartige Thermodenelemente weisen in der Regel zur Durchführung der Verschiebebewegung des Heizkörpers eine einfache Lagerung eines mit dem Heizkörper verbundenen Führungsteils auf. Weitere thermoden elemente werden in us 4,605,833 oder EP 1 204 137 gezeigt.

Mit zunehmender Miniaturisierung der zu montierenden Halbleiterbauelemente ist während der durch den Heizkörper durchgeführten Druckbeaufschlagung eine zunehmende Gefahr der Zerstörung derartig kleiner Halbleiterbauelemente gegeben. Dies führt zu Funktionsstörungen der montierten Halbleiterbauelemente.

Üblicherweise werden bisher mit den bekannten Thermodenelementen Halbleiterbauelemente mit einer durch die Druckbeaufschlagung auf das Halbleiterbauelement ausgeübten Kraft von mehr als 2 N während des Aushärt- bzw. Ausheizvorganges angepresst. Geringere Kraftwerte sind aufgrund der Ausgestaltung bisheriger Thermodenelemente nicht einstellbar. Dies trifft insbesondere für kleinste Halbleiterbauelemente zu, bei welchen zum Erfüllen des Erfordernisses einer hohen Planparallelität zwischen der Unterseite des Heizkörpers und der Oberseite des zu montierenden Halbleiterbauteiles eine genaue Führung des verschiebbaren Heizkörpers entscheidend ist.

Demzufolge liegt der vorliegenden Erfindung die Aufgabe zugrunde, eine Thermodeneinheit für das Verbinden und/oder das elektrische Kontaktieren eines Halbleiterbauelementes mit einem Trägerelement und/oder einem weiteren Halbleiterbauelement zur Verfügung zu stellen, welche eine Aushärtung von verwendeten Klebstoffen bei einer auf das Halbleiterbauelement ausgeübten Anpresskraft von weniger als 2 N ermöglicht.

Diese Aufgabe wird gemäß den Merkmalen des Patentanspruches 1 gelöst.

Ein wesentlicher Punkt der Erfindung liegt darin, dass bei einer Thermodeneinheit zum Verbinden und/oder elektrischen Kontaktieren eines ersten Halbleiterbauelementes mit einem Trägerelement oder einem zweiten Halbleiterbauelement mittels Erwärmung eines Klebstoffes unter Druckbeaufschlagung ein mit einer verschiebbaren Heizkopfeinheit entlang der Längsachse verschiebbares Führungsteil an seiner Längsseite innerhalb eines Grundkörpers des Thermodenelementes linear kugel- oder rollengelagert ist und das Führungsteil an seinem der Heizkopfeinheit abgewandten ersten Seite kolbenartig ausgebildet ist, wobei das kolbenartige Ende von einer Innenwand eines im Grundkörper angeordneten komplementär ausgebildeten Kolbenaufnahmeraums mit einem Luftspalt beabstandet ist. Dies ermöglicht eine nahezu reibungsfreie Lagerung der Heizkopfeinheit, welche einen Heizkörper unterseitig beinhaltet, innerhalb des Grundkörpers der Thermodeneinheit und somit die Dosierung kleinster Kräfte der mit dem Führungsteil verbundenen nach unten drückenden Heizkopfeinheit während des Aushärtevorganges der Klebstoffes. Auf diese Weise können Anpresskraftwerte für das Anpressen des ersten Halbleiterbauelementes auf dem Trägerelement bzw. dem zweiten Halbleiterbauelement von weniger als 2 N, vorzugsweise von 0,5 N ― 2 N erhalten werden, während die geforderte Planparallelität der Heizkopfeinheiten bei Vorliegen eines Bau- bzw. Montageraumes mit sehr geringen Abmessungen realisierbar sind.

Aufgrund der Linear-Kugel- oder Rollenführung ist die bei kleinsten Halbleiterbauteilen zwingend notwendige hohe Führungsgenauigkeit während des Verschiebens der Heizkopfeinheit unter Erhalt geringster Reibungskräfte sichergestellt.

In dem Kolbenaufnahmeraum wird der pneumatische Druck verändert, um als Verschiebeantrieb einen pneumatischen Staudruckzylinder aufzubauen, der sich unter anderem dadurch auszeichnet, dass zwischen einer Innenwand des Kolbenaufnahmeraumes und dem als Kolben ausgebildeten kolbenartigen Ende ein Luftspalt aufgrund des Überdrucks erzeugt wird. Dies führt dazu, dass der Kolben die Innenwand nicht berührt und somit nahezu keine Reibungskräfte während einer Verschiebebewegung des Führungsteils auftreten.

Zur Veränderung des Drucks innerhalb des Kolbenaufnahmeraumes ist dieser mit einem Druckventil verbunden.

Für die Realisierung der linearen Kugel- oder Rollelagerung weist das Führungsteil an seiner Längsseite eine in ihrem Querschnitt im Wesentlichen rechteckförmige erste Schiene auf, die innerhalb einer am Grundkörper befestigten gleich langen in ihrem Querschnitt im Wesentlichen U-förmigen zweiten Schiene kugelgelagert angeordnet ist.

Gemäß einer bevorzugten Ausführungsform ist das Führungsteil und/oder die erste Schiene mit veränderbaren Gewichtskörpern zur Einstellung eines nach unten wirkenden Anpressdrucks verbunden. Hierfür sind die Gewichtskörper innerhalb eines an der ersten Schiene oder dem Führungsteil seitlich angebrachten Aufnahmebehälters angeordnet. Dies hat zur Folge, dass der Kolben innerhalb des Kolbenaufnahmeraumes auch dann nicht die Innenwand des Kolbenaufnahmeraumes berührt, wenn ein aufgrund des Luftspaltes erzeugter Ringspalt zwischen Kolben und Innenwand schwierig einstellbar ist. Dies kann sich beispielsweise aufgrund von Fertigungstoleranzen ergeben. Zur Aufrechterhaltung des Ringspaltes wäre dann ein hoher Luftdruck innerhalb des Kolbenaufnahmeraumes und somit ein hoher Luftverbrauch durch unterseitiges Austreten aus dem Ringspalt gegeben. Dies kann durch die als Kalibriergewichte ausgebildeten Gewichtskörper ausgeglichen werden. Insbesondere kann durch derartige Kalibriergewichte eine exakte Kalibrierung mehrerer nebeneinander angeordneter Thermodenelemente untereinander erreicht werden.

Vorzugsweise setzt sich die Heizkopfeinheit aus einem unterseitigen das erste Halbleiterbauelement kontaktierbaren Heizkörper, einen mit einem dem ersten Halbleiterbauelemente zugewandten Ende des Führungsteils verbundenes Befestigungsteil und einem zwischen dem Befestigungsteil und dem Heizkörper angeordneten Wärmeisolationsteil zusammen. Der Heizkörper, der Kolbenaufnahmeraum und der Kolben selbst sind zur optimal dosierten Kraftausübung auf das zu montierende Halbleiterbauelement entlang einer gemeinsamen Achse angeordnet.

Weitere vorteilhafte Ausführungsformen ergeben sich aus den Unteransprüchen.

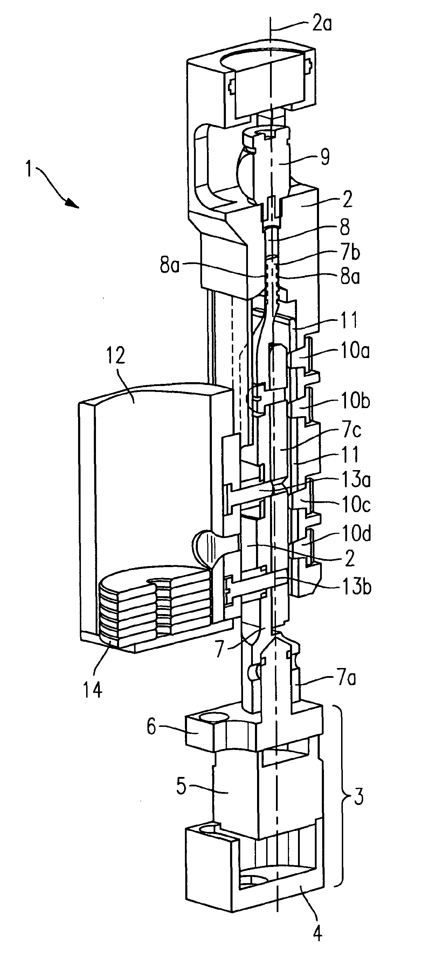

Vorteile und Zweckmäßigkeiten sind der nachfolgenden Beschreibung in Verbindung mit der Zeichnung zu entnehmen.

Die einzige Figur zeigt in einer perspektivischen Querschnittsdarstellung eine Thermodeneinheit gemäß einer Ausführungsform der Erfindung.

Die in der Figur gezeigte Thermodeneinheit 1 kann zur Montage, also Fixierung und elektrischen Kontaktierung von RFID-Chips auf UHF-Antennen, welche auf einem Träger, wie beispielsweise einer Chipkarte angeordnet sind, zur Herstellung eines RFID-Transponders verwendet werden.

Das Thermodenelement 1 umfasst einen Grundkörper 2 mit einer Längsachse 2a und einer unterseitig angeordneten Heizkopfeinheit 3, welche aus dem einen eigentlichen Heizkörper 4, einem wärmeisolierenden Teil 5 und einem Befestigungsteil 6 zum Befestigen der Heizkopfeinheit 3 an einem Führungsteil 7 besteht. Das Befestigungsteil 6 ist an einem unteren Ende 7a des Führungsteils 7 angeordnet.

Das Führungsteil 7 erstreckt sich innerhalb des Grundkörpers 2 bis zu seinem oberseitigen Ende 7b, welche kolbenartig ausgebildet ist. Der hierdurch gebildete Kolben 7b ist innerhalb eines Kolbenaufnahmeraumes 8, welcher innerhalb des Grundkörpers 2 angeordnet ist, verschiebbar gelagert.

Zwischen Innenwänden 8a des Kolbenaufnahmeraumes 8 und dem Kolben 7b ist ein hier nicht näher dargestellter Luftspalt vorhanden, der aufgrund eines in dem Kolbenaufnahmeraum 8 bestehenden veränderbaren pneumatischen Überdrucks von 1 ― 6 bar entsteht.

Zur Erzeugung des Veränderbaren pneumatischen Drucks innerhalb des Kolbenaufnahmeraums 8 ist über einen Pneumatik-Anschluss 9, welcher mit einem hier nicht näher dargestellten Proportional-Druckventil verbunden ist, Luft in den Kolbenaufnahmeraum einleitbar. Dies bewirkt eine Verschiebung des Kolbens 7b und somit eine Auf- oder Abwärtsbewegung des Heizkörpers 4.

Der Heizkörper weist vorzugsweise eine unterseitige Flächenabmessung von 13 x 13 mm auf, wie es für kleinste Silizium-Chips erforderlich ist.

Eine mit dem Führungsteil 7 verbundene Schiene 7c mit einer Länge von vorzugsweise 30 mm ist innerhalb einer mit dem Grundkörper 2 fest verbundenen U-förmig ausgebildeten Schiene 11 derart verbunden, dass zwischen beiden Schienen 7c und 11 bei Verschieben der Schiene 7c relativ zu der Schiene 11 eine lineare Kugellagerung wirkt. Zur Befestigung der Schiene 11 an dem Grundkörper 2 sind in diesen Schraubverbindungen 10a, 10b, 10c, und 10d angeordnet.

Um eine Kalibrierung mehrerer nebeneinander angeordneter Thermodenelemente zueinander zu erreichen, sind innerhalb eines seitlich angebrachten Behälters 12 Kalibriergewichte 14 angeordnet, deren Anzahl verändert werden kann. Der Behälter 12 ist über Verbindungselemente 13a und 13b dem Führungsteil 7 bzw. der Schiene 7c verbunden. Die zweite Schiene 11 weist vorzugsweise die gleiche Länge wie die erste Schiene 7c auf, um eine hohe Führungsgenauigkeit während des Verschiebens des Führungsteils und damit der Heizkopfeinheit 3 zu erhalten.

Sowohl der Kolbenaufnahmeraum 8 als auch der eigentliche Kolben 7b und die Heizkopfeinheit 3 sind entlang der gemeinsamen Längsachse 2ä des Grundkörpers 2 angeordnet, um eine optimale über die Fläche des Montierenden Halbleiterbauteiles gleichmäßig verteilte Kraft nach unten auszuüben.

### Bezugszeichenliste

- 1: Thermodeneinheit
- 2: Grundkörper
- 2a: Längsachse des Grundkörpers
- 3: Heizkopfeinheit
- 4: Heizkörper
- 5: Isolierteil
- 6: Befestigungsteil
- 7: Führungsteil
- 7a: unteres Ende des Führungsteils
- 7b: oberes Ende des Führungsteils
- 7c: erste Schiene
- 8: Kolbenaufnahmeraum
- 8a: Innenwände des Kolbenaufnahmeraumes
- 9: Pneumatik-Anschluss
- 10a, 10b, 10c, 10d: Schraubverbindungen
- 11: zweite Schiene
- 12: Behälter
- 13a, 13b: Verbindungselemente
- 14: Kalibriergewichte

## Patentansprüche

1. Thermodeneinheit zum Verbinden und/oder elektrischen Kontaktieren eines ersten Halbleiterbauelementes mit einem Trägerelement und/oder einem zweiten Halbleiterbauelement mittels Erwärmung eines Klebstoffes unter Druckbeaufschlagung, wobei die Thermodeneinheit (1) einen Grundkörper (2) und eine entlang seiner Längsachse (2a) verschiebbare Heizkopfeinheit (3) zum Anpressen des ersten Halbleiterbauelementes auf dem Trägerelement und/oder dem zweiten Halbleiterbauelement während einer Wärmeübertragung auf das erste Halbleiterbauelement umfasst,
**dadurch gekennzeichnet, dass**
ein mit der Heizkopfeinheit (3) entlang der Längsachse (2) verschiebbares Führungsteil (7) an seiner Längsseite innerhalb des Grundkörpers (2) linear kugel- oder rollengelagert ist und
das Führungsteil (7) an seinem der Heizkopfeinheit (3) abgewandten ersten Ende (7b) kolbenartig ausgebildet ist, welches von einer Innenwand (8a) eines im Grundkörper (2) angeordneten komplementär ausgebildeten Kolbenaufnahmeraums (8) durch einen Luftspalt beabstandet ist.

2. Thermodeneinheit nach Anspruch 1,
**dadurch gekennzeichnet, dass**
mittels einem Druckventil innerhalb des Kolbenaufnahmeraums (8) ein variierbarer, pneumatischer Druck zum Verschieben des kolbenartigen Endes (7b) des Führungsteils (7) entlang der Längsachse (2a) des Grundkörpers (2) einstellbar ist.

3. Thermodeneinheit nach Anspruch 1 oder 2,
**dadurch gekennzeichnet, dass**
das Führungsteil (7) an seiner Längsseite eine in ihrem Querschnitt im Wesentlichen rechteckförmige erste Schiene (7c) aufweist, die innerhalb einer am Grundkörper (2) befestigten gleich langen in ihrem Querschnitt im Wesentlichen U-förmigen zweiten Schiene (11) kugelgelagert angeordnet ist.

4. Thermodeneinheit nach einem der vorangegangenen Ansprüche,
**dadurch gekennzeichnet, dass**
das Führungsteil (7) und/oder die erste Schiene (7c) mit veränderbaren Gewichtskörpern (14) zur Einstellung eines nach unten wirkenden Anpressdrucks verbunden sind/ist.

5. Thermodeneinheit nach Anspruch 4,
**dadurch gekennzeichnet, dass**
die Gewichtskörper (14) innerhalb eines an der ersten Schiene (7c) oder dem Führungsteil (7) seitlich angebrachten Aufnahmebehälters (12) angeordnet sind.

6. Thermodeneinheit nach einem der vorangegangenen Ansprüche,
**dadurch gekennzeichnet, dass**
die Heizkopfeinheit (3) einen das erste Halbleiterbauelement kontaktierbaren Heizkörper (4), ein mit einem den ersten Halbleiterbauelement zugewandten Ende (7a) des Führungsteils (7) verbundenes Befestigungsteil (6) und ein zwischen dem Befestigungsteil (6) und dem Heizkörper (4) angeordnetes Wärmeisolationsteil (5) umfasst.

7. Thermodeneinheit nach Anspruch 6,
**dadurch gekennzeichnet, dass**
der Kolbenaufnahmeraum (8), das kolbenartige Ende (7b) und der Heizkörper (4) entlang einer gemeinsamen Achse (2a) angeordnet sind.

8. Thermodeneinheit nach einem der vorangegangenen Ansprüche,
**dadurch gekennzeichnet, dass**
das erste Halbleiterbauelement ein RFID-Chip und das Trägerelement ein an seiner Oberseite eine Antenne aufweisender Träger sind.

## Claims

1. A thermode unit for connecting and/or electrical contact making of a first semiconductor component with a carrier element and/or a second semiconductor component by means of heating of an adhesive under pressure application, wherein the thermode unit (1) comprises basic body (2) and a heating head unit (3) which is slidable along its longitudinal axis (2a) for pressing the first semiconductor component against the carrier element and/or the second semiconductor component against the first semiconductor component during heat transfer,
**characterised in that**
a guide part (7) which is slidable together with the heating head unit (3) along the longitudinal axis (2a) is linearly supported by a ball or roller bearing, and
the guide part (7) is formed piston-like at its first end (7b) which faces away from the heating head unit (3), which is spaced by an air gap from an inner wall (8a) of a complementarily formed piston reception space (8).

2. The thermode unit according to Claim 1,
**characterised in that** a variable pneumatic pressure for shifting the piston-like end (7b) of the guide part (7) may be adjusted by means of a pressure valve disposed within the piston reception pace (8).

3. The thermode unit according to Claim 1 or 2,
**characterised in that**
the guide part (7) comprises a first rail (7c) with an essentially rectangular cross-section at its longitudinal side, which is arranged via a ball bearing within a second rail (11) of identical length and an essentially U-shaped cross-section, which is fastened at the basic body (2).

4. The thermode unit according to one of the previous claims,
**characterised in that**
the guide part (7) and/or the first rail (7c) is/are connected with variable weight bodies (14) for the adjustment of a contact pressure acting in a downward direction.

5. The thermode unit according to Claim 4,
**characterised in that**
the weight bodies (14) are arranged within an reception container (12) which is attached at the first rail (7c) or at the side of the guide part (7).

6. The thermode unit according to one of the previous claims,
**characterised in that**
the heating head unit (3) comprises a heating body (4) which may contact the first semiconductor component, a fastening part (6) which is connected with an end (7a) of the guide part (7), which faces the first semiconductor component, and a heat insulation part (5) which is arranged between the fastening part (6) and the heating body (4).

7. The thermode unit according to Claim 6,
**characterised in that**
the piston reception space (8), the piston-line end (7b), and the heating body (4) are arranged along a common axis (2a).

8. The thermode unit according to one of the previous claims,
**characterised in that**
the first semiconductor component is an RFID chip and the carrier element is a carrier which comprises an antenna on its top surface.

## Revendications

1. Unité à thermode pour assurer l'assemblage et/ou l'établissement d'un contact électrique d'un premier composant à semi-conducteur avec un élément de support et/ou avec un deuxième composant à semi-conducteur, au moyen de l'échauffement d'une colle sous sollicitation de compression, l'unité à thermode (1) comprenant un corps de base (2) et une unité de tête chauffante (3) apte à coulisser le long de l'axe longitudinal (2a) du corps de base, pour appliquer sous pression le premier composant à semi-conducteur sur l'élément de support et/ou sur le deuxième composant à semi-conducteur pendant que s'effectue une transmission de chaleur vers le premier composant à semi-conducteur,
**caractérisée en ce qu'**une partie de guidage (7) susceptible de coulisser avec l'unité de tête chauffante (3) le long de l'axe longitudinal (2a), est montée en étant guidée linéairement par billes ou par rouleaux sur son côté longitudinal, à l'intérieur du corps de base (2), et
**en ce que** la partie de guidage (7) est réalisée à la manière d'un piston à sa première extrémité (7b) opposée à l'unité de tête chauffante (3), ladite extrémité étant espacée par un interstice d'air d'une paroi intérieure (8a) d'une chambre de réception de piston (8) de configuration complémentaire et formée dans le corps de base (2).

2. Unité à thermode selon la revendication 1,
**caractérisée en ce qu'**au moyen d'une soupape de pression, il est possible de régler à l'intérieur de la chambre de réception de piston (8), une pression pneumatique variable, pour faire coulisser l'extrémité (7b) en forme de piston de la partie de guidage (7), le long de l'axe longitudinal (2a) du corps de base (2).

3. Unité à thermode selon la revendication 1 ou la revendication 2,
**caractérisée en ce que** la partie de guidage (7) présente sur son côté longitudinal, une première glissière (7c) de section transversale sensiblement de forme rectangulaire, qui est montée, en étant guidée par billes, à l'intérieur d'une deuxième glissière (11) de même longueur, de section transversale sensiblement en forme de U, et fixée au corps de base (2).

4. Unité à thermode selon l'une des revendications précédentes,
**caractérisée en ce que** la partie de guidage (7) et/ou la première glissière (7c) est/sont reliée(s) à des masselottes (14) que l'on peut faire varier, pour régler une pression d'application dirigée vers le bas.

5. Unité à thermode selon la revendication 4,
**caractérisée en ce que** les masselottes (14) sont disposées à l'intérieur d'un réceptacle de logement (12) placé latéralement sur la première glissière (7c) ou la partie de guidage (7).

6. Unité à thermode selon l'une des revendications précédentes,
**caractérisée en ce que** l'unité de tête chauffante (3) comprend un corps chauffant (4) pouvant entrer en contact avec le premier composant à semi-conducteur, une partie de fixation (6) reliée à l'extrémité (7a) de la partie de guidage (7), qui est dirigée vers le premier composant à semi-conducteur, et une partie d'isolation thermique (5) agencée entre la partie de fixation (6) et le corps chauffant (4).

7. Unité à thermode selon la revendication 6,
**caractérisée en ce que** la chambre de réception de piston (8), l'extrémité (7b) en forme de piston et le corps chauffant (4) sont agencés le long d'un axe commun (2a).

8. Unité à thermode selon l'une des revendications précédentes,
**caractérisée en ce que** le premier composant à semi-conducteur est une puce RFID et l'élément de support est un support présentant une antenne sur sa surface supérieure.
